# EUROPÄISCHE PATENTSCHRIFT

(11) **EP 3 519 848 B1**
(45) Veröffentlichungstag und Bekanntmachung des Hinweises auf die Patenterteilung: **29.10.2025**
(21) Anmeldenummer: 17777193.8
(22) Anmeldetag: 15.09.2017
(51) Int. Cl.: G01S 7/484, H01S 5/023, H01S 5/0233

(54) **OPTISCHER PULSGENERATOR UND VERFAHREN ZUM BETRIEB EINES OPTISCHEN PULSGENERATORS**
OPTICAL PULSE GENERATOR AND METHOD FOR OPERATION OF AN OPTICAL PULSE GENERATOR
GÉNÉRATEUR DES IMPULSIONS OPTIQUES ET PROCÉDÉ POUR OPÉRATION D'UN GÉNÉRATEUR DES IMPULSIONS OPTIQUES

(30) Priorität: 30.09.2016 DE 102016118580
(43) Veröffentlichungstag der Anmeldung: 07.08.2019
(73) Patentinhaber: Ferdinand-Braun-Institut gGmbH, Leibniz-Institut für Höchstfrequenztechnik, 12489 Berlin (DE)
(72) Erfinder: LIERO, Armin, 13187 Berlin (DE); KLEHR, Andreas, 13156 Berlin (DE); HOFFMANN, Thomas, 13437 Berlin (DE)
(74) Vertreter: Gulde & Partner
(86) Internationale Anmeldenummer: PCT/EP2017/073232
(87) Internationale Veröffentlichungsnummer: WO 2018/059965

(56) Entgegenhaltungen:
- EP-A2- 2 963 445
- CN-A- 102 610 998
- CN-A- 105 699 709
- JP-A- 2015 065 255
- JP-A- H06 334 169
- JP-A- S6 367 792
- US-A1- 2015 229 912

## Beschreibung

Die vorliegende Erfindung betrifft ein LiDAR-System und ein Verfahren zum Betrieb eines LiDAR-Systems. Insbesondere betrifft die vorliegende Erfindung ein LiDAR-System aufweisend einen optischen Pulsgenerator für eine Hochfrequenz (HF)-Pulsweitenmodulation.

### Stand der Technik

LiDAR (light detection and ranging) ist eine Methode zur optischen Abstands- und Geschwindigkeitsmessung mit Laserstrahlen. Zunehmend werden LiDAR-Systeme auch in Kraftfahrzeugen, insbesondere zur Erkennung von Hindernissen, eingesetzt. Entsprechende LiDAR-Systeme zum Einsatz in Kraftfahrzeugen sind beispielsweise aus der US 7,969,588 B2 bekannt.

Im Allgemeinen arbeiten solche Systeme jedoch mit einer festen Pulsweite, so dass zuverlässige Messungen nur mit einer begrenzten Anzahl unabhängig arbeitender Systeme durchgeführt werden können. Werden die Signale einer Vielzahl von Systemen überlagert, beispielsweise in dichtem Stadtverkehr mit einer Vielzahl von reflektierenden Hindernissen, so sind zuverlässige Detektionen nicht mehr möglich. Durch den zunehmenden Einsatz von LiDAR steigt daher die Gefahr von entsprechend folgenschweren Fehlinterpretationen. Eine bei verwandten Radarsystemen übliche Autokorrelation der ausgesendeten und empfangenen Signale zur Verbesserung der Signalerkennung ist im optischen Bereich nur mit erheblichem technologischem Aufwand möglich.

Eine Möglichkeit zur eindeutigen Identifizierung der einzelnen LiDAR-Signale ist das Aufprägen einer individuellen Signatur mittels einer Pulsweitenmodulation. Eine solche Modulation ist jedoch nur mit einer sehr schnellen Logik-Schaltung und einem sehr induktionsarmen Aufbau zum Erreichen der notwendigen Schaltzeiten realisierbar.

Laserdioden und andere Strahlung emittierende optische Bauelemente auf Halbleiterbasis (z.B. Lumineszenzdioden, optische Verstärkerelemente) weisen im Allgemeinen noch keine entsprechende Elektronik für eine schnelle gepulste Ansteuerung auf. Einzelne Chips werden von einem Herstellungswafer vereinzelt und üblicherweise über eine externe elektronische Schaltung angesteuert.

Der Anschluss der Laserdioden erfolgt hierbei häufig über eine Vielzahl von einzelnen Bonddrähten, die eine leitende Verbindung zwischen Kontaktflächen an der Oberfläche der Laserdiode und entsprechenden Kontaktflächen der elektronischen Schaltung ausbilden. Um insbesondere bei Hochleistungslaserdioden eine einheitliche Stromdichte innerhalb der aktiven Schicht zu erreichen, wird üblicherweise eine Vielzahl von Bonddrähten mit geringem Querschnitt möglichst gleichmäßig über die gesamte Laserlänge verteilt. Aufgrund des geringen Querschnitts der Bonddrähte und der großen, vom Strom umspannten Fläche weisen solche Verbindungen für die geplante Anwendung zu hohe Induktivitäten auf. Durch die Verwendung von Bändchen zur Kontaktierung können die auftretenden Induktivitäten zwar gesenkt werden, diese sind jedoch insbesondere für eine schnelle HF-Pulsweitenmodulation der emittierten Strahlung noch immer viel zu hoch. Typische Induktivitäten beim Drahtbonden sind 0.8 - 1.0 nH/mm Bonddrahtlänge.

Aus der US 2015/0229912 A1 ist ein VCSEL-Array für eine 3D-Kamera mit Laufzeiterfassung bekannt, bei der das optische Bauelement und ein entsprechender Treiber auf einem gemeinsamen Baugruppenträger angeordnet sind. Die CN 102 610 998 B offenbart einen gepulsten Halbleiterlaser, bei dem das Treibermodul und das Lasermodul über ein einfaches Koaxialkabel miteinander verbunden sind. Die JP H06 334169 A lehrt die Anpassung der elektronischen Ankopplung eines optischen Bauelements an eine Ansteuerleitung in Form eines Mikrostreifenleiters. Die JP 2016-14665 A betrifft das Problem einer Verkürzung der Länge einer Verdrahtung zwischen einem lichtemittierenden Element und einer zugehörigen Steuerschaltung. Weiteren Stand der Technik stellen JP S63 67792 A, EP 2 963 445 A2 und JP 2015 065255 A dar.

### Offenbarung der Erfindung

Es ist daher eine Aufgabe der vorliegenden Erfindung, ein LiDAR-System und ein Verfahren zum Betrieb eines LiDAR-Systems anzugeben, welche die beschriebenen Nachteile des Standes der Technik überwinden. Insbesondere soll ein optischer Pulsgenerator eines erfindungsgemäßen LiDAR-Systems eine HF-Pulsweitenmodulation in LiDAR-Systemen ermöglichen.

Diese Aufgaben werden erfindungsgemäß durch die Merkmale der unabhängigen Patentansprüche 1 und 7 gelöst. Zweckmäßige Ausgestaltungen der Erfindung sind in den Unteransprüchen enthalten.

Ein erfindungsgemäßes LiDAR-System weist einen optischen Pulsgenerator auf, wobei der Pulsgenerator umfasst: ein aktives optisches Bauelement, dazu ausgebildet, optische Strahlung zu emittieren, wobei das optische Bauelement Kontaktflächen für eine elektrische Kontaktierung aufweist; ein Mittel zur elektronischen Ansteuerung des optischen Bauelements, dazu ausgebildet, das optisches Bauelement zu einer gepulsten Emission optischer Strahlung anzuregen, wobei das Mittel zur elektronischen Ansteuerung Kontaktflächen für eine elektrische Kontaktierung sowie elektronische Bauelemente aufweist; einen ersten Baugruppenträger, wobei das Mittel zur elektronischen Ansteuerung auf dem ersten Baugruppenträger angeordnet ist, wobei die elektronischen Bauelemente auf einer ersten Seite des ersten Baugruppenträgers angeordneten sind, die Kontaktflächen auf einer gegenüberliegenden zweiten Seite des ersten Baugruppenträgers angeordnet sind und eine Verbindung der elektronischen Bauelemente mit den Kontaktflächen über elektrisch leitende Durchführungen im ersten Baugruppenträger erfolgt; einen zweiten Baugruppenträger, wobei das optische Bauelement auf dem zweiten Baugruppenträger angeordnet ist, wobei das optische Bauelement zwischen dem ersten Baugruppenträger und dem zweiten Baugruppenträger angeordnet ist; und wobei mindestens eine Kontaktfläche des Mittels zur elektronischen Ansteuerung direkt oder mittels Lotpunkt mit mindestens einer Kontaktfläche des optischen Bauelements verbunden ist. Dabei ist das erfindungsgemäße LiDAR-System dadurch gekennzeichnet, dass das optische Bauelement in einer Aussparung in der Oberfläche des zweiten Baugruppenträgers vollständig versenkt ist; oder dass es sich bei dem ersten Baugruppenträger um eine flexible Leiterplatte und bei dem Mittel zur elektronischen Ansteuerung um eine Hochfrequenzschaltung zur elektronischen Anregung des optischen Bauelements zu einer gepulsten Emission optischer Strahlung handelt. Vorzugsweise handelt es sich bei einem aktiven optischen Bauelement um eine Laserdiode, eine Lumineszenzdiode oder um ein optisches Verstärkerelement. Das optische Bauelement kann mehrere Kontaktflächen für eine elektrische Kontaktierung aufweisen. Als Kontaktflächen werden dabei vorzugsweise an der Oberfläche eines optischen Bauelements für eine Kontaktierung vorgesehene elektrisch leitfähige Flächenelemente verwendet. Die Kontaktflächen können an einer einzelnen oder an verschiedenen Oberflächen des optischen Bauelements ausgebildet sein.

Vorzugsweise handelt es sich bei dem Mittel zur elektronischen Ansteuerung des optischen Bauelements um eine an die elektronischen Parameter des aktiven optischen Bauelements angepasste Treiberschaltung zur hochfrequenten Pulserzeugung. Das Mittel zur elektronischen Ansteuerung ist bevorzugt dazu ausgebildet, das optische Bauelement über hochfrequente Hochstrompulse anzusteuern. Insbesondere kann das Mittel zur elektronischen Ansteuerung die Hochstrompulse in Bezug zur Mittenposition des optischen Bauelements einseitig oder beidseitig erzeugen. Die Treiberschaltung kann dabei aus einem oder mehreren Paaren von Ansteuertransistoren und Speicherkondensatoren aufgebaut sein. Die Kontaktflächen zur Kontaktierung des Mittels zur elektronischen Ansteuerung bestehen vorzugsweise aus einem elektrisch leitfähigen Material (z.B. Metall). Das Mittel zur elektronischen Ansteuerung kann neben den genannten elektronischen Bauelementen und den Kontaktflächen auch noch weitere elektronische Bauelemente, Leiterbahnen und Verbindungselemente umfassen.

Bei dem ersten Baugruppenträger handelt es sich erfindungsgemäß ein spezielles, flexibles Leiterplattenmaterial es kann sich bevorzugt um LTCC (Keramik) handeln. Das Mittel zur elektronischen Ansteuerung kann dabei fest mit dem ersten Baugruppenträger verbunden sein. Ein Beispiel für ein solches fest mit einem Baugruppenträger verbundenes Mittel zur elektronischen Ansteuerung ("Schaltung") ist eine fertig bestückte und beschaltete Platine.

Bei dem zweiten Baugruppenträger kann es sich bevorzugt um einen Kühlkörper handeln. Das optische Bauelement kann dabei fest oder lösbar-fest (z.B. mit einem lösbaren Kleber aufgeklebt) mit dem Kühlkörper verbunden sein. Vorzugsweise handelt es sich um eine metallischen Kühlkörper mit großer Oberfläche. Ebenfalls bevorzugt ist, dass der zweite Baugruppenträger aus einem elektrisch leitfähigen Material besteht. Dadurch wird ermöglicht, dass eine Bestromung des optischen Bauelements auch über den zweiten Baugruppenträger erfolgen kann. Ein Stromeintrag kann jedoch auch ausschließlich aus Richtung des ersten Baugruppenträgers erfolgen.

Erfindungsgemäß weist der zweite Baugruppenträger eine Aussparung in einer seiner Oberflächen auf, in welcher das optische Bauelement vollständig versenkt werden kann. Bevorzugt bilden die die Aussparung enthaltende Oberfläche des zweiten Baugruppenträgers und die nach außen zeigende Oberfläche des in der Aussparung vollständig versenkten optischen Bauelements eine gemeinsame Ebene aus.

Die Idee der vorliegenden Erfindung besteht darin, dass zur Verwendung eines optischen Pulsgenerators in einem LiDAR-System durch eine möglichst direkte Kopplung zwischen dem optischen Bauelement (z.B. Laser) und dem Mittel zur elektronischen Ansteuerung (Ansteuerelektronik) eine hybride Integration ohne parasitäre induktive Effekte durch die Zuleitungen erfolgen kann. Dies wird insbesondere durch eine unmittelbare Integration des optischen Bauelements in die Schaltung der Ansteuerelektronik ermöglicht, wodurch äußerst geringe Induktivitäten erreicht werden können. Dies kann insbesondere durch einen geringen räumlichen Abstand zwischen den einzelnen Schaltungselementen, eine möglichst große Breite der Zuleitungen innerhalb des Mittels zur elektronischen Ansteuerung mit einer Anpassung der Breite an die aktive Länge des optischen Bauelements sowie ein geringer Abstand zwischen den Zuleitungen erreicht werden. Letzteres wird insbesondere durch die Verwendung von Verdrahtungsträgern (d.h. erster Baugruppenträger) erreicht, welche aus einem besonders dünnen Dielektrikum (z.B. aus einem speziellen, flexiblen Leiterplattenmaterial oder aus LTCC (Keramik)) bestehen. Die typischerweise mit einem erfindungsgemäßen optischen Pulsgenerator erreichte Gesamtinduktivität liegt bei ca. 100 - 200pH.

Durch die Vermeidung herkömmlicher Bonddrähte oder Kontaktbändchen können die auftretenden Induktivitäten deutlich herabgesetzt werden. Durch die geringen Induktivitäten kann neben einem schnellen Anschalten auch ein schnelles Abschalten der erzeugten Strahlungspulse erfolgen. Dies ermöglicht insbesondere eine besonders hochfrequente Pulsweitenmodulation im optischen Bereich zum Aufprägen einer individuellen Pulsweitensignatur. Vorzugsweise liegen die Schaltzeiten der Pulse im einstelligen ns-Bereich, bevorzugter im ps-Bereich.

Vorzugsweise erfolgt der Systemaufbau für Messzwecke mittels einer Andrucktechnik (Einklemmen) oder zum praktischen Einsatz über eine direkte Verbindung zwischen mindestens einer Kontaktfläche des Mittels zur elektronischen Ansteuerung und mindestens einer Kontaktfläche des optischen Bauelements. Das optische Bauelement kann dazu bevorzugt zwischen dem ersten Baugruppenträger und dem zweite Baugruppenträger eingeklemmt werden. Das Klemmen kann mittels einer geeigneten Fixier- oder Haltevorrichtung erfolgen. Als mögliche Alternativen zur direkten Klemmung können auch Klebungen oder Lötungen eingesetzt werden.

Vorzugsweise ist das Mittel zur elektronischen Ansteuerung dazu ausgebildet ist, über eine variable Pulsbreitenmodulation den vom optischen Bauelement emittierten Strahlungspulsen eine individuelle Signatur aufzuprägen. Bei dieser individuellen Signatur kann es beispielsweise um ein vorab festgelegtes Schema zur Pulsweitenmodulation, eine zufällig für einzelne Pulse oder Pulsfolgen festgelegte Pulsfolgevariation oder ein sonstiges zur eindeutigen Pulszuordnung geeignetes Modulationsschema handeln.

Erfindungsgemäß sind die elektronischen Bauelemente des Mittels zur elektronischen Ansteuerung auf einer ersten Seite des ersten Baugruppenträgers angeordnet, während die Kontaktflächen des Mittels zur elektronischen Ansteuerung auf einer der ersten Seite gegenüberliegenden zweiten Seite des ersten Baugruppenträgers angeordnet sind.

Es sind die elektronischen Bauelemente und die Kontaktflächen durch Leiterbahnen miteinander zu einer Schaltung verbunden. Zur Verbindung der auf der ersten Seite des ersten Baugruppenträgers angeordneten elektronischen Bauelemente mit den auf der gegenüberliegenden zweiten Seite des ersten Baugruppenträgers befindlichen Kontaktflächen werden erfindungsgemäß elektrisch leitende Durchführungen (Vias) im ersten Baugruppenträger eingesetzt.

In einer ersten Ausführungsform der vorliegenden Erfindung erfolgt eine zweipolige Bestromung des optischen Bauelements einseitig von der dem ersten Baugruppenträger zugewandten Oberfläche des optischen Bauelements aus. Eine Bestromung erfolgt somit ausschließlich über den ersten Baugruppenträger.

In einer zweiten Ausführungsform der vorliegenden Erfindung kann eine zweipolige Bestromung des optischen Bauelements sowohl von der dem ersten Baugruppenträger zugewandten Oberfläche des optischen Bauelements (mit einer ersten Polarität) als auch von der dem zweiten Baugruppenträger zugewandten Oberfläche des optischen Bauelements (mit einer zweiten Polarität) erfolgen. In diesem Fall erfolgt die Bestromung sowohl über den ersten als auch über den zweiten Baugruppenträger.

Insbesondere die durch die geringe Induktivität des optischen Pulsgenerators ermöglichte hochfrequente Pulsweitenmodulation erlaubt dabei die Aufprägung einer individuellen Pulssignatur zur eindeutigen Pulsidentifikation bei LiDAR-Systemen. Durch eine entsprechende Bandbreite bei der Pulsweitenmodulation können auch bei einer Vielzahl voneinander unabhängiger LiDAR-Signalen zuverlässige Messungen durchgeführt werden. Die vorliegende Erfindung umfasst weiterhin ein Verfahren zum Betrieb eines optischen Pulsgenerators in einem erfindungsgemäßen LiDAR-System, umfassend das Bereitstellen aktiven optischen Bauelements, wobei das optische Bauelement Kontaktflächen für eine elektrische Kontaktierung aufweist; das Bereitstellen des Mittels zur elektronischen Ansteuerung des optischen Bauelements, wobei das Mittel zur elektronischen Ansteuerung Kontaktflächen für eine elektrische Kontaktierung sowie elektronische Bauelemente aufweist; das Bereitstellen eines ersten Baugruppenträgers, wobei das Mittel zur elektronischen Ansteuerung auf dem ersten Baugruppenträger angeordnet wird, wobei die elektronischen Bauelemente auf der ersten Seite des ersten Baugruppenträgers angeordnet werden, die Kontaktflächen auf der gegenüberliegenden zweiten Seite des ersten Baugruppenträgers angeordnet werden und eine Verbindung der elektronischen Bauelemente mit den Kontaktflächen über elektrisch leitende Durchführungen im ersten Baugruppenträger erfolgt; Bereitstellen des zweiten Baugruppenträgers, wobei das optische Bauelement auf dem zweiten Baugruppenträger angeordnet wird, wobei das optische Bauelement in der Aussparung in der Oberfläche des zweiten Baugruppenträgers vollständig versenkt ist, oder wobei es sich bei dem ersten Baugruppenträger um die flexible Leiterplatte und bei dem Mittel zur elektronischen Ansteuerung um die Hochfrequenzschaltung zur elektronischen Anregung des optischen Bauelements zu einer gepulsten Emission optischer Strahlung handelt; das Anordnen des optischen Bauelements zwischen dem ersten Baugruppenträger und dem zweiten Baugruppenträger, wobei mindestens eine Kontaktfläche des Mittels zur elektronischen Ansteuerung direkt mit den Kontaktflächen des optischen Bauelements verbunden wird; das Einklemmen des optischen Bauelements zwischen dem ersten Baugruppenträger und dem zweite Baugruppenträger; und das Anregen des optischen Bauelements zu einer gepulsten Emission optischer Strahlung über das Mittel zur elektronischen Ansteuerung.

Das erfindungsgemäße Verfahren eignet sich insbesondere zur Überprüfung einzelner optischer Bauelemente. Ein gemäß dem genannten Verfahren zum Betrieb eines optischen Pulsgenerators zur gepulsten Emission optischer Strahlung angeregtes optisches Bauelement kann durch eine erfindungsgemäße Klemmung (d.h. Pressung der HF-Schaltung direkt auf das optische Bauelement) zerstörungsfrei im Kurzpulsbetrieb getestet werden, wobei ein schnelles Wechseln des optischen Bauelements ohne umfangreiche Bondprozesse ermöglicht wird.

### Kurzbeschreibung der Zeichnungen

Die Erfindung wird nachfolgend in Ausführungsbeispielen anhand der zugehörigen Zeichnung erläutert. Es zeigen:
- Fig. 1: eine schematische Darstellung einer ersten Ausführungsform eines optischen Pulsgenerators bei einem erfindungsgemäßen LiDAR-System und
- Fig. 2: eine schematische Darstellung einer zweiten Ausführungsform eines optischen Pulsgenerators bei einem erfindungsgemäßen LiDAR-System.

### Ausführliche Beschreibung der Zeichnungen

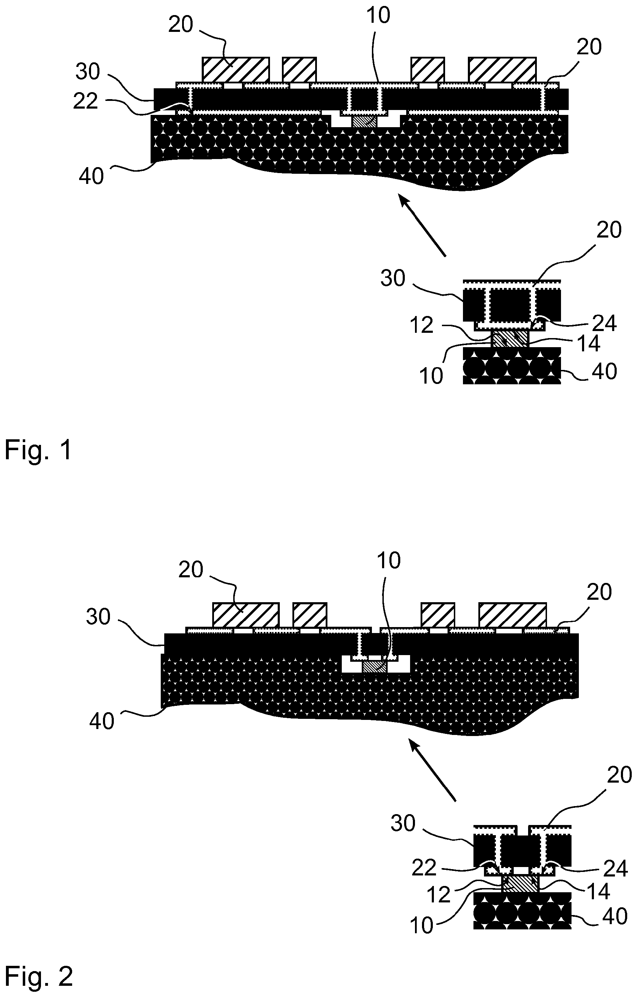

Fig. 1 zeigt eine schematische Darstellung einer ersten Ausführungsform eines optischen Pulsgenerators bei einem erfindungsgemäßen LiDAR-System. Das optische Bauelement 10 ist in einer Aussparung in der Oberfläche des zweiten Baugruppenträgers 40 vollständig versenkt, wobei insbesondere die in Richtung des ersten Baugruppenträgers 30 gerichtete Oberfläche des zweiten Baugruppenträgers 40 mit der ebenfalls in Richtung des ersten Baugruppenträgers 30 gerichteten Oberfläche des optischen Bauelements 10 eine gemeinsame Ebene ausbilden. In einer solchen Anordnung kann jedoch die in Richtung des ersten Baugruppenträgers 30 gerichtete Oberfläche des optischen Bauelements 10 auch oberhalb oder unterhalb der in Richtung des ersten Baugruppenträgers 30 gerichteten Oberfläche des zweiten Baugruppenträgers 40 ausgerichtet sein.

Der erste Baugruppenträger 30 dient als Träger für das Mittel zur elektronischen Ansteuerung 20, welches im dargestellten Ausführungsbeispiel aus verschiedenen elektronischen Bauteilen, Leiterbahnen und mindestens zwei zur Kontaktierung ausgebildeten Kontaktfläche 22, 24 aufgebaut ist. Vorzugsweise sind, wie auch in Fig. 1 gezeigt, die elektronischen Bauteile auf einer den Kontaktflächen 22, 24 gegenüberliegenden Seite des erste Baugruppenträgers 30 (d.h. auf der Oberseite des ersten Baugruppenträgers 30) angeordnet, wobei elektrisch leitende Verbindungen zwischen den die elektronischen Bauteile zu einer Schaltung verbindenden Leiterbahnen an der Oberseite des ersten Baugruppenträger 30 und den auf der Unterseite des Baugruppenträgers 30 befindlichen Kontaktflächen 12, 14 durch den ersten Baugruppenträger 30 hindurch geführt sind (Vias).

Das Mittel zur elektronischen Ansteuerung 20 ist dazu ausgebildet, Hochstrompulse zur elektronischen Anregung des optische Bauelements10 beidseitig in Bezug zur Mittenposition des optischen Bauelements 10 in das optische Bauelement einzukoppeln, d.h. die Hochstrompulse werden sowohl von den angeordneten elektronischen Bauteilen links vom optischen Bauelement 10 als auch von den angeordneten elektronischen Bauteilen rechts vom optischen Bauelement 10 erzeugt.

Das optische Bauelement 10 ist vorzugsweise zwischen dem ersten Baugruppenträger 30 und dem zweite Baugruppenträger 40 eingeklemmt, wobei mindestens eine Kontaktfläche 14 des optischen Bauteils 10 mindestens eine Kontaktfläche 24 des Mittels zur elektronischen Ansteuerung 20 kontaktiert. Die Kontaktierung kann dabei allein durch Berührung der Kontaktflächen 14, 24 oder mittels Lotpunkt zwischen den Kontaktflächen 14, 24 erfolgen. Im Übrigen kann jedes als elektrisch leitfähiger Kontaktvermittler wirkende Kontaktmittel für eine Verbesserung der Kontaktierung eingesetzt werden (z.B. grafithaltige elektrisch leitfähige Paste mit Korrosionsschutz).

Bei der dargestellten Ausführungsform weist das Mittel zur elektronischen Ansteuerung 20 mindestens eine weitere Kontaktfläche 22 auf, welche keinen direkten Kontakt zu mindestens einer Kontaktfläche 12 des optischen Bauelements 10 aufweist. Vorzugsweise umfasst der zweite Baugruppenträger 40 ein elektrisch leitfähiges Material (z.B. ein Metall), welches dazu ausgebildet ist, einen Stromfluss zwischen der Kontaktfläche 12 des optischen Bauelements 10 und der Kontaktfläche 22 des Mittels zur elektronischen Ansteuerung 20 über den zweiten Baugruppenträger 40 zu ermöglichen. Vorzugsweise besteht der gesamte zweite Baugruppenträger 40 aus einem thermisch und elektrisch leitfähigen Material (z.B. Silber, Kupfer, Gold, Aluminium). Bei dem gezeigten Ausführungsbeispiel erfolgt eine Bestromung des optischen Bauelements 10 somit aus sich gegenüberliegenden Seiten des optischen Bauelements 10.

Fig. 2 zeigt eine schematische Darstellung einer zweiten Ausführungsform eines optischen Pulsgenerators bei einem erfindungsgemäßen LiDAR-System. Der prinzipielle Aufbau entspricht weitestgehend der in Fig.1 dargestellten Ausführungsform. Die jeweiligen Bezugszeichen und deren Zuordnung gelten entsprechend. Im Unterschied zu Fig. 1 erfolgt eine Bestromung des optischen Bauelements 10 hierbei ausschließlich von einer Seite des optischen Bauelements 10. Die in Richtung des ersten Baugruppenträgers 30 gerichtete Oberfläche des optischen Bauelements 10 ist unterhalb der in Richtung des ersten Baugruppenträgers 30 gerichteten Oberfläche des zweiten Baugruppenträgers 40 ausgerichtet, so dass die auf der Unterseite des ersten Baugruppenträgers angeordneten und voneinander unabhängigen Kontaktflächen 22, 24 des Mittels zur elektronischen Ansteuerung 20 plan auf der Oberfläche des darunter liegenden optisches Bauelements 10, d.h. auf den dort befindlichen Kontaktflächen 12, 14 des optischen Bauelements 10, aufliegen.

### Bezugszeichenliste

- 10: Optisches Bauelement
- 12: Kontaktfläche (optisches Bauelement 10)
- 14: Kontaktfläche (optisches Bauelement 10)
- 20: Mittel zur elektronischen Ansteuerung
- 22: Kontaktfläche (Mittel zur elektronischen Ansteuerung 20)
- 24: Kontaktfläche (Mittel zur elektronischen Ansteuerung 20)
- 30: erster Baugruppenträger
- 40: zweiter Baugruppenträger

## Patentansprüche

1. LiDAR-System, aufweisend einen optischen Pulsgenerator, umfassend:
a) ein aktives optisches Bauelement (10), dazu ausgebildet, optische Strahlung zu emittieren, wobei das optische Bauelement (10) Kontaktflächen (12, 14) für eine elektrische Kontaktierung aufweist;
b) ein Mittel zur elektronischen Ansteuerung (20) des optischen Bauelements (10), dazu ausgebildet, das optisches Bauelement (10) zu einer gepulsten Emission optischer Strahlung anzuregen, wobei das Mittel zur elektronischen Ansteuerung (20) Kontaktflächen (22, 24) für eine elektrische Kontaktierung sowie elektronische Bauelemente aufweist;
c) einen ersten Baugruppenträger (30), wobei das Mittel zur elektronischen Ansteuerung (20) auf dem ersten Baugruppenträger (30) angeordnet ist, wobei die elektronischen Bauelemente auf einer ersten Seite des ersten Baugruppenträgers (30) angeordneten sind, die Kontaktflächen (22, 24) auf einer gegenüberliegenden zweiten Seite des ersten Baugruppenträgers (30) angeordnet sind und eine Verbindung der elektronischen Bauelemente mit den Kontaktflächen (22, 24) über elektrisch leitende Durchführungen im ersten Baugruppenträger (30) erfolgt;
d) einen zweiten Baugruppenträger (40), wobei das optische Bauelement (10) auf dem zweiten Baugruppenträger (40) angeordnet ist;
e) wobei das optische Bauelement (10) zwischen dem ersten Baugruppenträger (30) und dem zweiten Baugruppenträger (40) angeordnet ist; und
f) wobei mindestens eine Kontaktfläche (22, 24) des Mittels zur elektronischen Ansteuerung (20) direkt oder mittels Lotpunkt mit mindestens einer Kontaktfläche (12, 14) des optischen Bauelements (10) verbunden ist;
g) wobei das optische Bauelement (10) in einer Aussparung in der Oberfläche des zweiten Baugruppenträgers (40) vollständig versenkt ist; oder
h) wobei es sich bei dem ersten Baugruppenträger (30) um eine flexible Leiterplatte und bei dem Mittel zur elektronischen Ansteuerung (20) um eine Hochfrequenzschaltung zur elektronischen Anregung des optischen Bauelements (10) zu einer gepulsten Emission optischer Strahlung handelt.

2. LiDAR-System gemäß Anspruch 1, wobei die Kontaktflächen (22, 24) des Mittels zur elektronischen Ansteuerung (20) aus einem Metall sind.

3. LiDAR-System gemäß einem der voranstehenden Ansprüche, wobei es sich bei dem Mittel zur elektronischen Ansteuerung (20) um eine an die elektronischen Parameter des optischen Bauelements (10) angepasste Treiberschaltung zur hochfrequenten Pulserzeugung handelt.

4. LiDAR-System gemäß einem der voranstehenden Ansprüche, wobei eine Bestromung des optischen Bauelements (20) über den ersten Baugruppenträger (30) und den zweiten Baugruppenträger (40) oder ausschließlich über den ersten Baugruppenträger (30) erfolgt.

5. LiDAR-System gemäß einem der voranstehenden Ansprüche, wobei das optische Bauelement (10) zwischen dem ersten Baugruppenträger (30) und dem zweiten Baugruppenträger (40) eingeklemmt wird.

6. LiDAR-System gemäß einem der voranstehenden Ansprüche, wobei das Mittel zur elektronischen Ansteuerung (20) dazu ausgebildet ist, über eine variable Pulsbreitenmodulation den vom optischen Bauelement (10) emittierten Strahlungspulsen eine individuelle Signatur aufzuprägen.

7. Verfahren zum Betrieb eines optischen Pulsgenerators in einem LiDAR-System gemäß einem der voranstehenden Ansprüche, umfassend:
a) Bereitstellen des aktiven optischen Bauelements (10), wobei das optische Bauelement (10) Kontaktflächen (12, 14) für eine elektrische Kontaktierung aufweist;
b) Bereitstellen des Mittels zur elektronischen Ansteuerung (20) des optischen Bauelements (10), wobei das Mittel zur elektronischen Ansteuerung (20) Kontaktflächen (22, 24) für eine elektrische Kontaktierung sowie elektronische Bauelemente aufweist;
c) Bereitstellen des ersten Baugruppenträgers (30), wobei das Mittel zur elektronischen Ansteuerung (20) auf dem ersten Baugruppenträger (30) angeordnet wird, wobei die elektronischen Bauelemente auf der ersten Seite des ersten Baugruppenträgers (30) angeordneten werden, die Kontaktflächen (22, 24) auf der gegenüberliegenden zweiten Seite des ersten Baugruppenträgers (30) angeordnet werden und eine Verbindung der elektronischen Bauelemente mit den Kontaktflächen (22, 24) über elektrisch leitende Durchführungen im ersten Baugruppenträger (30) erfolgt;
d) Bereitstellen des zweiten Baugruppenträgers (40), wobei das optische Bauelement (10) auf dem zweiten Baugruppenträger (40) angeordnet wird; wobei das optische Bauelement (10) in der Aussparung in der Oberfläche des zweiten Baugruppenträgers (40) vollständig versenkt ist, oder es sich bei dem ersten Baugruppenträger (30) um die flexible Leiterplatte und bei dem Mittel zur elektronischen Ansteuerung (20) um die Hochfrequenzschaltung zur elektronischen Anregung des optischen Bauelements (10) zu einer gepulsten Emission optischer Strahlung handelt;
e) Anordnen des optischen Bauelements (10) zwischen dem ersten Baugruppenträger (30) und dem zweiten Baugruppenträger (40), wobei mindestens eine Kontaktfläche (22, 24) des Mittels zur elektronischen Ansteuerung (20) direkt mit den Kontaktflächen (12, 14) des optischen Bauelements (10) verbunden wird;
f) Einklemmen des optischen Bauelements (10) zwischen dem ersten Baugruppenträger (30) und dem zweiten Baugruppenträger (40);
g) Anregen des optischen Bauelements (10) zu einer gepulsten Emission optischer Strahlung über das Mittel zur elektronischen Ansteuerung (20).

## Claims

1. A LiDAR system with an optical pulse generator, comprising:
a) an active optical component (10) configured to emit optical radiation, wherein the optical component (10) has contact surfaces (12, 14) for electrical contacting;
b) a means for electronically driving (20) the optical component (10), configured to excite the optical component (10) to a pulsed emission of optical radiation, wherein the means for electronically driving (20) comprises contact surfaces (22, 24) for electrical contacting and electronic components;
c) a first submount (30), wherein the means for electronically driving (20) is arranged on the first submount (30), wherein the electronic components are arranged on a first side of the first submount (30), the contact surfaces (22, 24) are arranged on an opposite second side of the first submount (30), and the electronic components are connected to the contact surfaces (22, 24) via electrically conductive vias in the first submount (30);
d) a second submount (40), wherein the optical component (10) is arranged on the second submount (40);
e) wherein the optical component (10) is arranged between the first submount (30) and the second submount (40); and
f) wherein at least one contact surface (22, 24) of the means for electronically driving (20) is connected directly or by means of a solder point to at least one contact surface (12, 14) of the optical component (10);
g) wherein the optical component (10) is completely recessed in a recess in the surface of the second submount (40); or
h) wherein the first submount (30) is a flexible circuit board and the means for electronically driving (20) is a high-frequency circuit for electronically exciting the optical component (10) to a pulsed emission of optical radiation.

2. The LiDAR system according to claim 1, wherein the contact surfaces (22, 24) of the means for electronically driving (20) are made of a metal.

3. The LiDAR system according to one of the preceding claims, wherein the means for electronically driving (20) is a driver circuit for high-frequency pulse generation adapted to electronic parameters of the optical component (10).

4. The LiDAR system according to one of the preceding claims, wherein the optical component (20) is powered via the first submount (30) and the second submount (40) or exclusively via the first submount (30).

5. The LiDAR system according to one of the preceding claims, wherein the optical component (10) is clamped between the first submount (30) and the second submount (40).

6. The LiDAR system according to one of the preceding claims, wherein the means for electronically driving (20) is configured to apply an individual signature to radiation pulses emitted by the optical component (10) via variable pulse width modulation.

7. A method for operating an optical pulse generator in a LiDAR system according to one of the preceding claims, comprising:
a) providing the active optical component (10), wherein the optical component (10) comprises contact surfaces (12, 14) for electrical contacting;
b) providing the means for electronically driving (20) the optical component (10), wherein the means for electronically driving (20) comprises contact surfaces (22, 24) for electrical contacting and electronic components;
c) providing the first submount (30), wherein the means for electronically driving (20) is arranged on the first submount (30), wherein the electronic components are arranged on the first side of the first submount (30), the contact surfaces (22, 24) are arranged on the opposite second side of the first submount (30), and the electronic components are connected to the contact surfaces (22, 24) via electrically conductive vias in the first submount (30);
d) providing the second submount (40), wherein the optical component (10) is arranged on the second submount (40); wherein the optical component (10) is completely recessed in the recess in the surface of the second submount (40), or the first submount (30) is the flexible circuit board and the means for electronically driving (20) is the high-frequency circuit for electronically exciting the optical component (10) to a pulsed emission of optical radiation;
e) arranging the optical component (10) between the first submount (30) and the second submount (40), wherein at least one contact surface (22, 24) of the means for electronically driving (20) is directly connected to the contact surfaces (12, 14) of the optical component (10);
f) clamping the optical component (10) between the first submount (30) and the second submount (40);
g) exciting the optical component (10) to a pulsed emission of optical radiation via the means for electronically driving (20).

## Revendications

1. Système LiDAR comportant un générateur d'impulsions optiques, comprenant :
a) un composant optique (10) actif conçu pour émettre un rayonnement optique, ledit composant optique (10) comportant des surfaces de contact (12, 14) destinées à un contact électrique ;
b) un dispositif de commande électronique (20) du composant optique (10), conçu pour exciter le composant optique (10) à une émission pulsée de rayonnement optique, ledit dispositif de commande électronique (20) comportant des surfaces de contact (22, 24) pour un contact électrique ainsi que des composants électroniques ;
c) un premier support de module (30), le dispositif de commande électronique (20) étant disposé sur le premier support de module (30), les composants électroniques étant agencés sur une première face du premier support de module (30), et les surfaces de contact (22, 24) étant agencées sur une deuxième face opposée du premier support de module (30), et une connexion des composants électroniques avec les surfaces de contact (22, 24) étant réalisée par des traversées conductrices dans le premier support de module (30) ;
d) un second support de module (40), le composant optique (10) étant disposé sur le deuxième support de module (40) ;
e) le composant optique (10) étant disposé entre le premier support de module (30) et le second support de module (40) ; et
f) au moins une surface de contact (22, 24) du dispositif de commande électronique (20) étant reliée directement ou au moyen d'un point de soudure à au moins une surface de contact (12, 14) du composant optique (10) ;
g) le composant optique (10) étant entièrement encastré dans un évidement dans la surface du deuxième support de module (40) ; ou
h) le premier support de module (30) étant une carte de circuit imprimé flexible et le dispositif de commande électronique (20) étant un circuit haute fréquence destiné à exciter électroniquement le composant optique (10) pour l'émission d'un rayonnement optique pulsé.

2. Système LiDAR selon la revendication 1, dans lequel les surfaces de contact (22, 24) du dispositif de commande électronique (20) sont en métal.

3. Système LiDAR selon l'une des revendications précédentes, dans lequel le dispositif de commande électronique (20) est un circuit pilote pour la génération d'impulsions à haute fréquence adapté aux paramètres électroniques du composant optique (10).

4. Système LiDAR selon l'une des revendications précédentes, dans lequel l'alimentation électrique du composant optique (20) s'effectue par le premier support de module (30) et le deuxième support de module (40) ou exclusivement par le premier support de module (30).

5. Système LiDAR selon l'une des revendications précédentes, dans lequel le composant optique (10) est maintenu en position entre le premier support de module (30) et le deuxième support de module (40).

6. Système LiDAR selon l'une des revendications précédentes, dans lequel le dispositif de commande électronique (20) est conçu pour appliquer une signature individuelle aux impulsions de rayonnement émises par le composant optique (10), au moyen d'une modulation variable de la largeur d'impulsion.

7. Procédé de fonctionnement d'un générateur d'impulsions optiques dans un système LiDAR selon l'une des revendications précédentes, comprenant :
a) la fourniture du composant optique (10) actif, lequel composant optique (10) comporte des surfaces de contact (12, 14) pour un contact électrique ;
b) la fourniture du dispositif de commande électronique (20) du composant optique (10), le dispositif de commande électronique (20) comportant des surfaces de contact (22, 24) pour un contact électrique ainsi que des composants électroniques ;
c) la fourniture du premier support de module (30), le dispositif de commande électronique (20) étant positionné sur le premier support de module (30), les composants électroniques étant agencés sur la première face du premier support de module (30), les surfaces de contact (22, 24) étant agencées sur la seconde face opposée du premier support de module (30), et une connexion des composants électroniques avec les surfaces de contact (22, 24) étant réalisée par des traversées conductrices dans le premier support de module (30) ;
d) la fourniture du deuxième support de module (40), le composant optique (10) étant disposé sur le deuxième support de module (40) ; le composant optique (10) étant entièrement encastré dans l'évidement de la surface du deuxième support de module (40), ou le premier support de module (30) étant la carte de circuit imprimé flexible et le dispositif de commande électronique (20) étant constitué par le circuit haute fréquence destiné à exciter électroniquement le composant optique (10) en une émission pulsée de rayonnement optique ;
e) la disposition du composant optique (10) entre le premier support de module (30) et le deuxième support de module (40), au moins une surface de contact (22, 24) du dispositif de commande électronique (20) étant reliée directement aux surfaces de contact (12, 14) du composant optique (10) ;
f) le maintien en position du composant optique (10) entre le premier support de module (30) et le deuxième support de module (40) ;
g) l'excitation du composant optique (10) pour une émission pulsée de rayonnement optique via le dispositif de commande électronique (20).
